# EUROPEAN PATENT SPECIFICATION

(11) **EP 3 048 409 B1**
(45) Date of publication and mention of the grant of the patent: **17.07.2019**
(21) Application number: 16151147.2
(22) Date of filing: 13.01.2016
(51) Int. Cl.: F28F 3/12, B22F 3/105, F28D 20/02, H01L 23/373

(54) **COMPOSITE FLOW-THROUGH HEAT SINK SYSTEM AND METHOD**
ZUSAMMENGESETZTES DURCHFLUSSKÜHLKÖRPERSYSTEM UND VERFAHREN
SYSTÈME DE DISSIPATEUR DE CHALEUR À FLUX CONTINU COMPOSITE ET PROCÉDÉ

(30) Priority: 15.01.2015 US 201514597680
(43) Date of publication of application: 27.07.2016
(73) Proprietor: Hamilton Sundstrand Space Systems International, Inc., Windsor Locks, CT 06096 (US)
(72) Inventor: STIEBER, Jesse Joseph, Avon, CT 06001 (US)
(74) Representative: Dehns

(56) References cited:
- EP-A2- 2 543 950
- DE-A1- 10 065 594
- US-A1- 2008 105 413
- US-A1- 2010 326 627
- US-A1- 2012 240 919

## Description

### FIELD

The present disclosure relates heat sinks, and more particularly, to systems and methods of increasing the efficiency of heat sinks.

### BACKGROUND

A heat sink may be configured to transfer thermal energy from a higher temperature component to a lower temperature medium, such as a fluid medium. If the fluid medium is water, the heat sink may be referred to as a cold plate. In thermodynamics, a heat sink is a heat reservoir configured to absorb heat without significantly changing temperature. Heat sinks for electronic devices often have a temperature higher than the surroundings to transfer heat by convection, radiation, and/or conduction.

To understand the principle of a heat sink, consider Fourier's law of heat conduction. Fourier's law states that the rate of heat flow, dQ/dt, through a homogeneous solid is directly proportional to the area, A, of the section at right angles to the direction of heat flow, and to the temperature difference along the path of heat flow, dT/dx. (The proportionality ratio, λ, is the thermal conductivity of the material). Resulting in: dQ/dt = - λ A dT/dx.

Heat sink systems as defined in the preamble of claim 1 are taught in EP 2543950, US 2012/240919. DE 10065594 also discloses a heat sink system relevant to the invention.

### SUMMARY

The present disclosure relates to a flow-through heat sink system as defined by claim 1.

The flow-through heat sink system may include a heat sink surface disposed on an external surface of the enclosure. A wetted coupling may be formed between an interface between the conductive matrix and a surface of the enclosure in response to the additive manufacturing process occurring. The additive manufacturing process comprises successive layers of material being laid down under computer control to form a component. The additive manufacturing process comprises at least one of direct metal laser sintering, selective laser melting, or selective laser sintering. The flow of heat from a heat sink surface to the conductive matrix is direct through the enclosure to the conductive matrix. Stated another way, the coupling of the enclosure to the conductive matrix is free of intervening adhesives and/or bonding agents. The conductive matrix comprises a graphite matrix.

According to various embodiments, a method of forming a flow-through heat sink is provided as defined by claim 8.

The heat sink assembly enclosure includes a port configured to pass through at least one of the first portion of the heat sink assembly enclosure or the second portion of the heat sink assembly enclosure to the internal cavity. A phase change material is added to the internal cavity via the port. A heat sink surface may be disposed on an external surface of at least one of the first portion of the heat sink assembly enclosure or the second portion of the heat sink assembly enclosure. A wetted coupling may be formed between an interface between the conductive matrix and a surface of at least one of the first portion of the heat sink assembly enclosure or the second portion of the heat sink assembly enclosure in response to the additive manufacturing process occurring.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the detailed description and claims when considered in connection with the drawing figures, wherein like numerals denote like elements.
FIG. 1 depicts a representative heat sink device in accordance with various embodiments;
FIG. 2 depicts a representative composite flow-through heat sink, in accordance with various embodiments;
FIG. 3 depicts the cross-sectional view of the heat sink of FIG. 2, in accordance with various embodiments; and
FIG. 4 depicts a method for creating a flow-through heat sink assembly in accordance with various embodiments.

### DETAILED DESCRIPTION

The detailed description of exemplary embodiments herein makes reference to the accompanying drawings, which show exemplary embodiments by way of illustration and their best mode. While these exemplary embodiments are described in sufficient detail to enable those skilled in the art to practice the disclosure, it should be understood that other embodiments may be realized and that logical changes may be made without departing from the scope of the disclosure. Thus, the detailed description herein is presented for purposes of illustration only and not of limitation. For example, the steps recited in any of the method or process descriptions may be executed in any order and are not necessarily limited to the order presented. Furthermore, any reference to singular includes plural embodiments, and any reference to more than one component or step may include a singular embodiment or step.

The present disclosure relates to a heat sink, and more particularly a heat sink with desirable thermally conductive joints. Conventionally, phase change material (PCM) heat sinks use water, wax, fluid, or other materials with desirable melting points to store and release heat energy associated with the solid liquid phase change, called the latent heat of fusion. A traditional heat sink is made from a readily available material (e.g., aluminum or stainless steel), the joining of the different parts, fin or metal matrix to a thermal interface sheet is commonly done through a traditional braze process. This creates a structural and thermally conductive joint. These types of homogenous PCM heat sinks have a low PCM to structure mass ratio. To increase the PCM to structure mass ratio, a highly conductive light weight matrix material may be utilized, wherein the highly conductive light weight matrix materials are typically nonmetal materials. Conventionally, when joining nonmetal matrix materials to a metal thermal interface sheet, a bond or glue is applied between the nonmetal matrix and the thermal interface, (e.g., a heat sink surface). This creates a weak structural joint and a less than desirable thermally conductive joint. The glue adds a thermal resistance to the heat transfer path which is not present in a typical metal only joint.

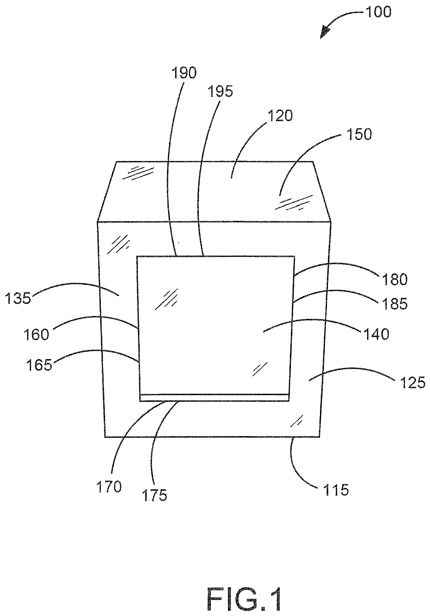

According to various embodiments and with reference to FIG. 1 a heat sink assembly 100 is depicted. An enclosure 150 housing a nonmetal matrix composite component 140 is depicted. At least one surface, such as top surface 120, of the enclosure 150 may be in contact and/or close proximity to a heat source. The nonmetal matrix composite component 140 may comprise any nonmetal matrix composite materials, for instance the nonmetal matrix composite may be a graphite matrix, such as Poco Foam®. Adhering the nonmetal matrix composite component 140 to the enclosure with adhesive may result in poor thermal conductivity through the adhesive. The systems and methods described herein may mitigate these thermal conductivity concerns.

According to various embodiments, an assembly 100 may be formed. The assembly 100 may comprise an enclosure 150. The enclosure 150 may be formed through any desired process. The enclosure 150 may be formed through an additive manufacturing process. Specifically, the enclosure 150 may be formed through an additive manufacturing process while the partially formed enclosure is in contact with a nonmetal matrix composite component 140. Additive manufacturing is the use of one of various processes to make a three-dimensional component.

Additive manufacturing may comprise successive layers of material being laid down under computer control to form a component. These objects can be of almost any shape or geometry, and are produced from a three dimensional model or other electronic data source.

Additive manufacturing processes include direct metal laser sintering (DMLS). DMLS is an additive manufacturing technique that uses a laser as a power source to sinter powdered material (typically metal), aiming the laser automatically at points in space defined by a 3D model, binding material together to create a solid structure. Additive manufacturing processes include selective laser melting. Selective laser melting is a process that uses 3D data, such as 3D computer aided design (CAD) data, as a digital information source and energy in the form of a high-power laser beam (such as a ytterbium fiber laser) to create a three-dimensional metal component by fusing metallic powders together. Additive manufacturing processes include selective laser sintering (SLS). SLS is a technique that uses a laser as a power source to sinter powdered material (typically metal), aiming the laser at points in space defined by a 3D model, binding the material together to create a solid structure. It is similar to DMLS.

The enclosure 150 may comprise at least one of a base 115, first side wall 135, second side wall 125 and top surface 120. Any surface, such as an external surface, of the enclosure 150 may comprise a heat sink surface. According to various embodiments, enclosure 150 may be partially formed. For instance, least one of a base 115, first side wall 135, second side wall 125 and top surface 120 may be formed, such as through an additive manufacturing process. A nonmetal matrix composite component 140 may be inserted within the partially formed enclosure 150. An integral bond may be formed between the exterior walls of the nonmetal matrix composite component 140 and the interior walls of the enclosure 150. For instance, the nonmetal matrix composite component 140 may comprise a first side wall 160, a second side wall 180, a top surface 190 and a bottom surface 170. The enclosure 150 may comprise an interior first side wall 165, a second interior side wall 185, an interior top surface 195, and an interior base surface 175. The interior shape and size of the enclosure 150 may be sized to approximately mirror the exterior shape and size of the nonmetal matrix composite component 140. Wetted bonds may be formed between at least one of the first side wall 160 and the interior first side wall 165; the second side wall 180 and the second interior side wall 185; the top surface 190 and the interior top surface 195; or the bottom surface 170 and an interior base surface 175. Wetting is the ability of a liquid to maintain contact with a solid surface, resulting from intermolecular interactions when the two are brought together. The degree of wetting (wettability) is determined by a force balance between the adhesive and cohesive forces present. In this way, the high heat conditions of the additive manufacturing process forming the enclosure 150 around the nonmetal matrix composite component 140 may cause a wetted condition to occur.

According to various embodiments, the high heat conditions of the additive manufacturing process forming the enclosure 150 around the nonmetal matrix composite component 140 and/or inserting the nonmetal matrix composite component 140 in a partially formed and still hot enclosure 150 cause a bond between adjacent dissimilar material surfaces to occur.

According to various embodiments, in this way, the conduction path is efficient as no foreign bonding agents are present. Stated another way, a glueless, bondless, coupling between the enclosure 150 and the nonmetal matrix composite component 140 creates an efficient conduction path, such as for a heat sink. By forming the enclosure 150 around the nonmetal matrix composite component 140, concerns of differences in thermal expansion between the enclosure 150 and the nonmetal matrix composite component 140 are mitigated.

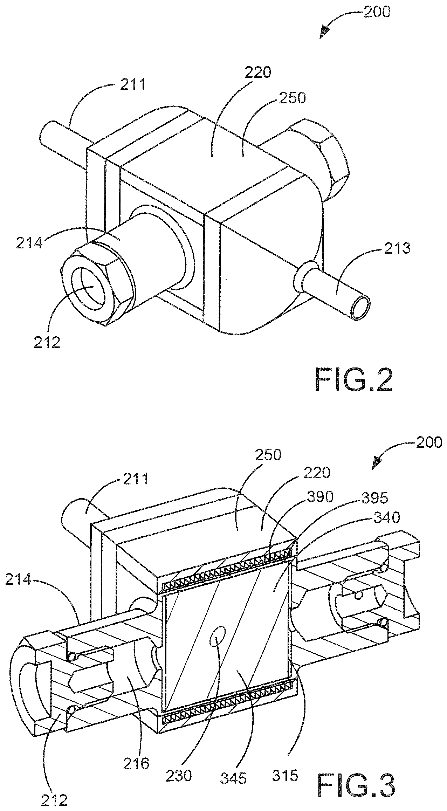

According to various embodiments, and with reference to FIGs. 2 and 3, a flow-through heat sink assembly 200 is depicted. Flow-through heat sink assembly 200 comprises a regenerative capability. Flow-through heat sink assembly 200 comprises an enclosure 250 which defines an internal cavity 315. A conductive matrix 340 may substantially fill the internal cavity 315. As described above with reference to assembly 100, enclosure 250 may be additively manufactured around the conductive matrix 340. The conductive matrix 340 may be made from any desired material; however, in various embodiments, the conductive matrix is a porous graphite matrix. The internal cavity may further comprise a phase change material (PCM) 345, such as wax. PCM 345 may be added to the internal cavity 315 at any time; however, according to various embodiments, PCM 345 is added to internal cavity 315 via port 216 of tube 214. Tube 214 may be closed in response to a desired volume of PCM 345 around conductive matrix 340 within internal cavity 315 being reached. Tube 214 may be closed via plug 212. The top surface 220 of enclosure 250 may be a heat sink surface. In this way, thermal energy may be transferred through top surface 220, across the efficient conductive interface between the interior top surface 395 of enclosure 250 to the top surface 390 of conductive matrix 340. The PCM 345 may store the energy by undergoing a phase change. Flow-through heat sink assembly 200 may comprise a flow-through channel 230. As depicted in FIGs. 2 and 3 flow-through channel 230 may pass through the interior of enclosure 250. In this way, a fluid may pass a heat transfer liquid through port 213, through a portion of flow-through channel 230 within enclosure 250, and out port 211. The liquid may bring heat to be dissipated to enclosure 250 and/or remove heat from enclosure 250. For instance, thermal energy may be introduced to a heat sink surface, such as the top surface 220 of enclosure 250. Thermal energy may pass directly through top surface 220 of enclosure 250 to the interior top surface 395 of enclosure 250. Thermal energy may pass from the interior top surface 395 of enclosure 250 to the top surface 390 of conductive matrix 340. The PCM 345 may store the energy by undergoing a phase change. Thermal energy may be passed from the PCM 345 to the fluid flowing through flow-through channel 230 and be released from flow-through heat sink assembly 200 via port 213 or port 211.

A reverse process may also occur. For instance, thermal energy may be introduced to flow-through heat sink assembly 200 via flow-through channel 230. The thermal energy may be passed from the fluid to PCM 345 within the enclosure 250. Thermal energy may transfer from PCM 345 to the conductive matrix 340. Thermal energy may pass from the conductive matrix 340 to the enclosure 250. Thermal energy may pass from an interior surface of the enclosure 250, such as the interior top surface 395 of enclosure 250, to a heat sink surface such as top surface 220 of enclosure 250.

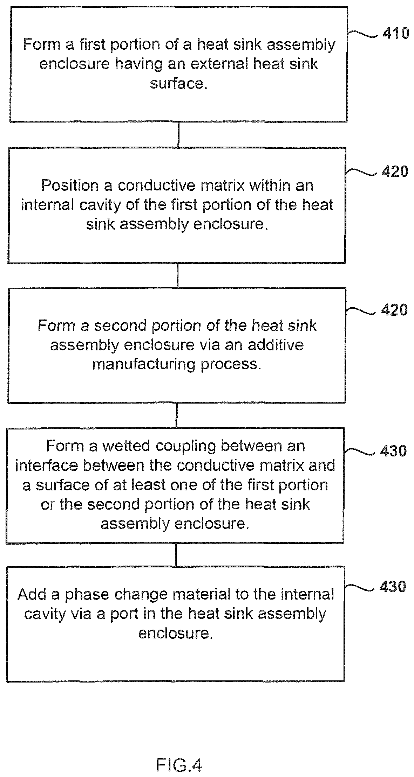

According to various embodiments, and with reference to FIG. 4, a method for creating a flow-through heat sink assembly 200 is described. The method may include, forming a first portion of a heat sink assembly enclosure having an external heat sink surface (Step 410). The first portion may comprise at least one of a base and one or more side walls. A conductive matrix may be positioned within an internal cavity of the first portion of the heat sink assembly enclosure (Step 420). This positioning may by any suitable process. For instance, the conductive matrix may be formed within the first portion of the heat sink assembly enclosure, such as by an additive manufacturing process, substantially in concert with the formation of at least one of a first portion of the heat sink assembly enclosure or the second portion of the heat sink assembly enclosure. A second portion of the heat sink assembly enclosure may be formed via an additive manufacturing process. (Step 420) A wetted coupling may be made between an interface between the conductive matrix and a surface of at least one of the first portion or the second portion of the heat sink assembly enclosure (Step 430). A phase change material may be added to the internal cavity via a port formed in the heat sink assembly enclosure (Step 430). A fluid may be passed through a flow-through channel 230 that traverses the interior of enclosure 250 for the delivery and/or removal of thermal energy.

As described herein, an additive manufacturing process is utilized to encapsulate a nonmetal matrix, such as conductive matrix 340 and create structural and thermally conductive joint at the thermal interface between conductive matrix 340 and its enclosure, such as enclosure 250. This is achieved via the metal of enclosure 250 wetting to the conductive matrix 340 which creates the flow-through heat sink assembly 200. Due it its lack of thermally resistive bonds at the metal to high conductivity matrix interface, flow-through heat sink assembly 200 has improved the heat transfer characteristics as compared with conventional heat sinks. The structural capacity of the flow-through heat sink assembly 200 is limited by the strength of the matrix not its bond joints.

Benefits, other advantages, and solutions to problems have been described herein with regard to specific embodiments. Furthermore, the connecting lines shown in the various figures contained herein are intended to represent exemplary functional relationships and/or physical couplings between the various elements. It should be noted that many alternative or additional functional relationships or physical connections may be present in a practical system. However, the benefits, advantages, solutions to problems, and any elements that may cause any benefit, advantage, or solution to occur or become more pronounced are not to be construed as critical, required, or essential features or elements of the disclosure. The scope of the disclosure is accordingly to be limited by nothing other than the appended claims, in which reference to an element in the singular is not intended to mean "one and only one" unless explicitly so stated, but rather "one or more."

Systems, methods and apparatus are provided herein. In the detailed description herein, references to "various embodiments", "one embodiment", "an embodiment", "an example embodiment", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments. Different cross-hatching is used throughout the figures to denote different parts but not necessarily to denote the same or different materials.

## Claims

1. A flow-through heat sink system comprising:
an enclosure (150;250) defining an internal cavity (315);
a conductive matrix (340) disposed within the internal cavity (315);
a phase change material (345) at least partially collocated with the conductive matrix (340) within the internal cavity (315); and
a flow-through channel (230) disposed within the internal cavity (315) in thermal contact with at least one of the conductive matrix (340) or the phase change material (345);
**characterised in that** the sink further comprises a port (216) configured to pass through an external surface of the enclosure (150;250) to the internal cavity (315); **in that**
the enclosure (150;250) is at least partially formed around the conductive matrix (340) via an additive manufacturing process; and wherein the phase change material (345) is added to the internal cavity (315) via the port (216).

2. The flow-through heat sink system of claim 1 , further comprising a heat sink surface (120;220) disposed on an external surface (120;220) of the enclosure (150;250).

3. The flow-through heat sink system of any preceding claim, wherein a wetted coupling is formed between the conductive matrix (340) and an interior surface of the enclosure (150;250) in response to the additive manufacturing process occurring,

4. The flow-through heat sink system of any preceding claim, wherein the additive manufacturing process comprises successive layers of material laid down under computer control to form a component.

5. The flow-through heat sink system of any preceding claim, wherein the additive manufacturing process comprises at least one of direct metal laser sintering, selective laser melting, or selective laser sintering.

6. The flow-through heat sink system of any preceding claim, wherein a flow of heat between the heat sink surface (120;220) and the conductive matrix (340) is direct through the enclosure (150;250) to the conductive matrix (340).

7. The flow-through heat sink system of any preceding claim, wherein the conductive matrix (340) comprises a graphite matrix.

8. A method comprising:
forming a first portion of a heat sink assembly enclosure (150;250);
positioning a conductive matrix (340) within an internal cavity (315) of the first portion of the heat sink assembly enclosure (150;250), wherein a flow-through channel (230) passes through the internal cavity (315); and
forming a second portion of the heat sink assembly enclosure (150;250);
**characterised in that** the method further comprises forming a port (216) configured to pass through at least one of the first portion of the heat sink assembly enclosure (150;250) or the second portion of the heat sink assembly enclosure (150;250) to the internal cavity (315); **in that**
at least one of the first portion of the heat sink assembly enclosure (150;250) or the second portion of the heat sink assembly enclosure (150;250) is formed via an additive manufacturing process; and further comprising adding a phase change material (345) to the internal cavity (315) via the port (216).

9. The method of claim 8, wherein a heat sink surface (120;220) is disposed on an external surface (120;220) of at least one of the first portion of the heat sink assembly enclosure (150;250) or the second portion of the heat sink assembly enclosure (150;250).

10. The method of any of claims 8 -9, further comprising forming a wetted coupling between an interface between the conductive matrix (340) and a surface of at least one of the first portion of the heat sink assembly enclosure (150;250) or the second portion of the heat sink assembly enclosure (150;250) in response to the additive manufacturing process occurring.

11. The method of any of claims 8-10, wherein the additive manufacturing process comprises at least one of direct metal laser sintering, selective laser melting, or selective laser sintering.

## Patentansprüche

1. Durchflusskühlkörpersystem, das Folgendes umfasst:
eine Umhüllung (150; 250), die einen inneren Hohlraum (315) definiert;
eine leitfähige Matrix (340), die innerhalb des inneren Hohlraums (315) angeordnet ist;
ein phasenveränderliches Material (345), das mindestens teilweise mit der leitfähigen Matrix (340) innerhalb des inneren Hohlraums (315) zusammengestellt ist; und
einen Durchflusskanal (230), der innerhalb des inneren Hohlraums (315) in einem thermischen Kontakt mit mindestens einem von der leitfähigen Matrix (340) oder dem phasenveränderlichen Material (345) angeordnet ist;
**dadurch gekennzeichnet, dass** der Körper ferner einen Anschluss (216) umfasst, der dazu konfiguriert ist, eine Außenfläche der Umhüllung (150; 250) zu dem inneren Hohlraum (315) zu durchqueren; dadurch, dass
die Umhüllung (150; 250) mindestens teilweise über ein additives Herstellungsverfahren um die leitfähige Matrix (340) ausgebildet ist; und wobei das phasenveränderliche Material (345) über den Anschluss (216) zu dem inneren Hohlraum (315) hinzugefügt wird.

2. Durchflusskühlkörpersystem nach Anspruch 1, ferner umfassend eine Kühlkörperfläche (120; 220), die auf einer Außenfläche (120; 220) der Umhüllung (150; 250) angeordnet ist.

3. Durchflusskühlkörpersystem nach einem der vorhergehenden Ansprüche, wobei als Reaktion auf das Stattfinden des additiven Herstellungsverfahrens eine benetzte Kopplung zwischen der leitfähigen Matrix (340) und einer Innenfläche der Umhüllung (150; 250) ausgebildet wird.

4. Durchflusskühlkörpersystem nach einem der vorhergehenden Ansprüche, wobei das additive Herstellungsverfahren aufeinanderfolgende Schichten von Material umfasst, die durch einen Computer gesteuert gestapelt werden, um ein Bauteil zu bilden.

5. Durchflusskühlkörpersystem nach einem der vorhergehenden Ansprüche, wobei das additive Herstellungsverfahren mindestens eines umfasst von einem Direkt-Metall-Lasersintern, einem selektiven Laserschmelzen oder einem selektiven Lasersintern.

6. Durchflusskühlkörpersystem nach einem der vorhergehenden Ansprüche, wobei ein Wärmefluss zwischen der Kühlkörperfläche (120; 220) und der leitfähigen Matrix (340) durch die Umhüllung (150; 250) zu der leitfähigen Matrix (340) geleitet wird.

7. Durchflusskühlkörpersystem nach einem der vorhergehenden Ansprüche, wobei die leitfähige Matrix (340) eine Graphitmatrix umfasst.

8. Verfahren, das Folgendes umfasst:
Bilden eines ersten Abschnitts einer Kühlkörperanordnungsumhüllung (150; 250);
Positionieren einer leitfähigen Matrix (340) innerhalb eines inneren Hohlraums (315) des ersten Abschnitts der Kühlkörperanordnungsumhüllung (150; 250), wobei ein Durchflusskanal (230) den inneren Hohlraum (315) durchquert; und
Bilden eines zweiten Abschnitts der Kühlkörperanordnungsumhüllung (150; 250);
**dadurch gekennzeichnet, dass** das Verfahren ferner ein Bilden eines Anschlusses (216) umfasst, der dazu konfiguriert ist, mindestens eines von dem ersten Abschnitt der Kühlkörperanordnungsumhüllung (150; 250) oder dem zweiten Abschnitt der Kühlkörperanordnungsumhüllung (150; 250) zu dem inneren Hohlraum (315) zu durchqueren;
dadurch, dass mindestens eines von dem ersten Abschnitt der Kühlkörperanordnungsumhüllung (150; 250) oder dem zweiten Abschnitt der Kühlkörperanordnungsumhüllung (150; 250) durch ein additives Herstellungsverfahren gebildet wird; und ferner umfassend ein Hinzufügen eines phasenveränderlichen Materials (345) zu dem inneren Hohlraum (315) über den Anschluss (216).

9. Verfahren nach Anspruch 8, wobei eine Kühlkörperfläche (120; 220) auf einer Außenfläche (120; 220) von mindestens einem von dem ersten Abschnitt der Kühlkörperanordnungsumhüllung (150; 250) oder dem zweiten Abschnitt der Kühlkörperanordnungsumhüllung (150; 250) angeordnet ist.

10. Verfahren nach einem der Ansprüche 8-9, ferner umfassend ein Bilden einer benetzten Kopplung zwischen einer Schnittstelle zwischen der leitfähigen Matrix (340) und einer Fläche von mindestens einem von dem ersten Abschnitt der Kühlkörperanordnungsumhüllung (150; 250) oder dem zweiten Abschnitt der Kühlkörperanordnungsumhüllung (150; 250) als Reaktion auf das Stattfinden des additiven Herstellungsverfahrens.

11. Verfahren nach einem der Ansprüche 8-10, wobei das additive Herstellungsverfahren mindestens eines umfasst von einem Direkt-Metall-Lasersintern, einem selektiven Laserschmelzen und einem selektiven Lasersintern.

## Revendications

1. Système de dissipateur de chaleur à flux continu comprenant :
une enceinte (150 ; 250) définissant une cavité interne (315) ;
une matrice conductrice (340) disposée à l'intérieur de la cavité interne (315) ;
un matériau à changement de phase (345) au moins partiellement co-implanté avec la matrice conductrice (340) à l'intérieur de la cavité interne (315) ; et
un canal à flux continu (230) disposé à l'intérieur de la cavité interne (315) en contact thermique avec au moins une de la matrice conductrice (340) ou du matériau à changement de phase (345) ;
**caractérisé en ce que** le dissipateur comprend en outre un orifice (216) configuré pour passer à travers une surface externe de l'enceinte (150 ; 250) vers la cavité interne (315) ; **en ce que** l'enceinte (150 ; 250) est au moins partiellement formée autour de la matrice conductrice (340) via un processus de fabrication additive ; et dans lequel le matériau à changement de phase (345) est ajouté à la cavité interne (315) via l'orifice (216).

2. Système de dissipateur de chaleur à flux continu selon la revendication 1, comprenant en outre une surface de dissipateur de chaleur (120 ; 220) disposée sur une surface externe (120 ; 220) de l'enceinte (150 ; 250).

3. Système de dissipateur de chaleur à flux continu selon une quelconque revendication précédente, dans lequel un couplage humidifié est formé entre la matrice conductrice (340) et une surface intérieure de l'enceinte (150 ; 250) en réponse à la production du processus de fabrication additive.

4. Système de dissipateur de chaleur à flux continu selon une quelconque revendication précédente, dans lequel le processus de fabrication additive comprend des couches successives de matériau, disposées sous contrôle informatique pour former un composant.

5. Système de dissipateur thermique à flux continu selon une quelconque revendication précédente, dans lequel le processus de fabrication additive comprend au moins l'un d'un frittage laser direct de métal, d'une fusion laser sélective ou d'un frittage laser sélectif.

6. Système de dissipateur thermique à flux continu selon une quelconque revendication précédente, dans lequel un flux de chaleur entre la surface de dissipateur de chaleur (120 ; 220) et la matrice conductrice (340) est direct à travers l'enceinte (150 ; 250) vers la matrice conductrice (340).

7. Système de dissipateur de chaleur à flux continu selon une quelconque revendication précédente, dans lequel la matrice conductrice (340) comprend une matrice de graphite.

8. Procédé comprenant :
la formation d'une première partie d'une enceinte d'ensemble dissipateur de chaleur (150 ; 250) ;
le positionnement d'une matrice conductrice (340) à l'intérieur d'une cavité interne (315) de la première partie de l'enceinte d'ensemble dissipateur de chaleur (150 ; 250), dans lequel un canal à flux continu (230) passe à travers la cavité interne (315) ; et
la formation d'une seconde partie de l'enceinte d'ensemble dissipateur de chaleur (150 ; 250) ;
**caractérisé en ce que** le procédé comprend en outre la formation d'un orifice (216) configuré pour passer à travers au moins une de la première partie de l'enceinte d'ensemble dissipateur de chaleur (150 ; 250) ou de la seconde partie de l'enceinte d'ensemble dissipateur de chaleur (150 ; 250) vers la cavité interne (315) ; **en ce que**
au moins une de la première partie de l'enceinte d'ensemble dissipateur de chaleur (150 ; 250) ou de la seconde partie de l'enceinte d'ensemble dissipateur de chaleur (150 ; 250) est formée via un processus de fabrication additive ; et comprenant en outre l'ajout d'un matériau à changement de phase (345) à la cavité interne (315) via l'orifice (216).

9. Procédé selon la revendication 8, dans lequel une surface de dissipateur de chaleur (120 ; 220) est disposée sur une surface externe (120 ; 220) d'au moins une de la première partie de l'enceinte d'ensemble dissipateur de chaleur (150 ; 250) ou de la seconde partie de l'enceinte d'ensemble dissipateur de chaleur (150 ; 250).

10. Procédé selon l'une quelconque des revendications 8 à 9, comprenant en outre la formation d'un couplage humidifié entre une interface entre la matrice conductrice (340) et une surface d'au moins une de la première partie de l'enceinte d'ensemble dissipateur de chaleur (150 ; 250) ou de la seconde partie de l'enceinte d'ensemble dissipateur de chaleur (150 ; 250) en réponse à la production du processus de fabrication additive.

11. Procédé selon l'une quelconque des revendications 8 à 10, dans lequel le processus de fabrication additive comprend au moins l'un d'un frittage laser de métal direct, d'une fusion laser sélective ou d'un frittage laser sélectif.
